(19) Europäisches Patentamt
European Patent Office
Office européen des brevets

(11) EP 1 988 630 A1

(12) EUROPEAN PATENT APPLICATION
published in accordance with Art. 158(3) EPC

(43) Date of publication:
**05.11.2008 Bulletin 2008/45**

(21) Application number: **07713846.9**

(22) Date of filing: **06.02.2007**

(51) Int Cl.:
***H03H 9/25*** *(2006.01)*

(86) International application number:
**PCT/JP2007/052017**

(87) International publication number:
**WO 2007/097186 (30.08.2007 Gazette 2007/35)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **20.02.2006 JP 2006042822**

(71) Applicant: **Murata Manufacturing Co. Ltd.**
**Nagaokakyo-shi, Kyoto 617-8555 (JP)**

(72) Inventors:
- **NAKAI, Yasuharu**
  **Nagaokakyo-shi**
  **Kyoto-fu 617-8555 (JP)**
- **NISHIYAMA, Kenji**
  **Nagaokakyo-shi**
  **Kyoto-fu 617-8555 (JP)**
- **NAKAO, Takeshi**
  **Nagaokakyo-shi**
  **Kyoto-fu 617-8555 (JP)**
- **KATO, Masanori**
  **Nagaokakyo-shi**
  **Kyoto-fu 617-8555 (JP)**
- **KADOTA, Michio**
  **Nagaokakyo-shi**
  **Kyoto-fu 617-8555 (JP)**

(74) Representative: **Thévenet, Jean-Bruno et al**
**Cabinet Beau de Loménie**
**158, rue de l'Université**
**75340 Paris Cédex 07 (FR)**

(54) **ELASTIC SURFACE WAVE DEVICE**

(57) A surface acoustic wave device utilizing a Rayleigh wave is provided. The surface acoustic wave device can reduce the generation of ripples and the influence of a spurious component due to an SH wave. Thus, the surface acoustic wave device has excellent frequency characteristics, as well as excellent temperature characteristics. A surface acoustic wave device (1) includes a $LiNbO_3$ substrate (2) having Euler angles (0° ± 5°, θ, 0° ± 10°); electrodes that are disposed on the $LiNbO_3$ substrate (2), are mainly composed of Cu, and include an IDT electrode (3); a first silicon oxide film (6) having the same thickness as the electrodes and disposed in an area other than an area on which the electrodes including the IDT electrode (3) are disposed; and a second silicon oxide film (7) disposed on the electrodes and the first silicon oxide film (6), wherein the Euler angle θ and the normalized thickness H of the second silicon oxide film (7) are selected to satisfy the formula (1) or (2).

$$-50 \times H^2 - 3.5 \times H + 38.275 \leq \{\theta\} \leq 10H + 35 \text{ (wherein } H < 0.25) \quad \text{Formula (1)}$$

$$-50 \times H^2 - 3.5 \times H + 38.275 \leq \{\theta\} \leq 37.5 \text{ (wherein } H \geq 0.25) \quad \text{Formula (2)}$$

EP 1 988 630 A1

FIG.1

(a)

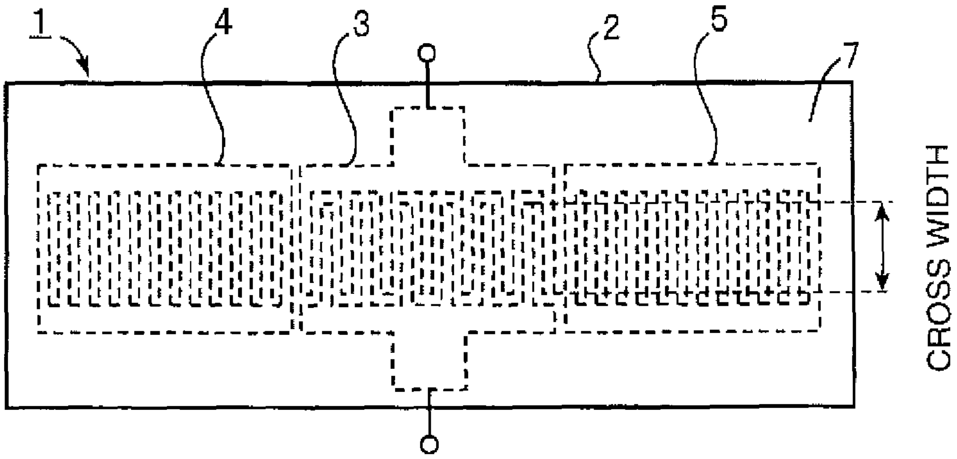


(b)

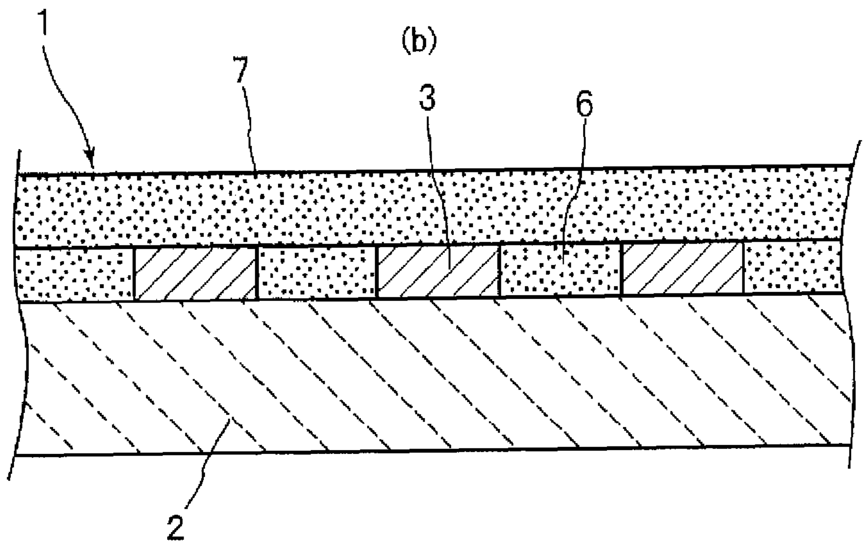

## Description

Technical Field

The present invention relates to a surface acoustic wave device used, for example, as a resonator or a band-pass filter and, more particularly, to a surface acoustic wave device in which an IDT electrode and a silicon oxide film are formed on a $LiNbO_3$ substrate and which utilizes a Rayleigh wave.

Background Art

Band-pass filters used for an RF stage in mobile phones are required to work for a wide frequency band over a wide range of temperatures. Thus, in existing surface acoustic wave devices, an IDT electrode is formed on a piezoelectric substrate of a rotated Y-cut X-propagating $LiTaO_3$ or $LiNbO_3$ substrate, and the IDT electrode is covered with a silicon oxide film. Because a piezoelectric substrate of this type has a negative temperature coefficient of frequency, an IDT electrode is covered with a silicon oxide film having a positive temperature coefficient of frequency to improve the temperature characteristics.

However, in such a structure, when the IDT electrode is formed of widely-used Al or Al alloy, the IDT electrode cannot have a sufficient reflection coefficient. This often causes ripples in the resonance characteristics.

To solve such a problem, Patent Document 1 discloses a surface acoustic wave device that includes a piezoelectric $LiNbO_3$ substrate having an electromechanical coupling coefficient $K^2$ of at least 0.025, an IDT electrode disposed on the piezoelectric substrate, the IDT electrode being formed mainly of a metal having a density higher than that of Al, a first silicon oxide film disposed in an area other than an area where the IDT electrode is disposed, the first silicon oxide film having the same thickness as the electrode, and a second silicon oxide film disposed on the electrode and the first silicon oxide film.

In the surface acoustic wave device according to Patent Document 1, the density of the IDT electrode is at least 1.5 times the density of the first silicon oxide film. Patent Document 1 claimed that this high density results in a sufficient increase in the reflection coefficient of the IDT electrode and a reduction in the generation of ripples in the resonance characteristics.

[Patent Document 1] WO 2005-034347

Disclosure of the Invention

However, in the surface acoustic wave device according to Patent Document 1, while the generation of ripples can be reduced in the vicinity of the resonance frequency, a relatively large spurious component was found at a frequency higher than the antiresonance frequency. More specifically, when the Rayleigh wave response is utilized, a large spurious component due to an SH wave response was found in the vicinity of the antiresonance frequency at a frequency higher than the antiresonance frequency of the Rayleigh wave.

Furthermore, in the surface acoustic wave device according to Patent Document 1, when power is turned on, the resonance frequency and the antiresonance frequency sometimes shift greatly to higher frequencies. This abnormal frequency shift over the frequency shift due to heat generation occurs at turn-on. The resonance frequency returns to a designed resonance frequency after the electric power is turned off. However, there is a high demand for the prevention of this abnormal frequency shift at turn-on.

The present invention aims to solve the problems of the related art. Accordingly, it is an object of the present invention to provide a surface acoustic wave device that includes a silicon oxide film covering an IDT electrode to improve the temperature characteristics. In the surface acoustic wave device, not only the reflection coefficient of the IDT electrode is increased to reduce the generation of ripples in the resonance characteristics, but also the generation of a spurious component at a frequency higher than the antiresonance frequency of Rayleigh wave response is reduced effectively. Thus, the surface acoustic wave device according to the present invention has further improved frequency characteristics.

It is another object of the present invention to provide a surface acoustic wave device in which an abnormal resonance frequency shift at turn-on can be reduced.

The present invention provides a surface acoustic wave device utilizing a Rayleigh wave, including a $LiNbO_3$ substrate having Euler angles ($0° \pm 5°$, $\theta$, $0° \pm 10°$); electrodes that are disposed on the $LiNbO_3$ substrate, are mainly composed of Cu, and include at least one IDT electrode; a first silicon oxide film having the same thickness as the electrodes and disposed in an area other than an area on which the electrodes are disposed; and a second silicon oxide film disposed on the electrodes and the first silicon oxide film, wherein the density of the electrodes is at least 1.5 times as high as the density of the first silicon oxide film, and the normalized thickness H of the second silicon oxide film and $\theta$ of the Euler angles ($0° \pm 5°$, $\theta$, $0° \pm 10°$) satisfy the formula (1) or (2).

[Formula 1]

$$-50 \times H^2 - 3.5 \times H + 38.275 \leq \{\theta\} \leq 10H + 35 \text{ (wherein } H < 0.25) \quad \text{Formula (1)}$$

[Formula 2]

$$-50 \times H^2 - 3.5 \times H + 38.275 \leq \{\theta\} \leq 37.5 \text{ (wherein } H \geq 0.25) \quad \text{Formula (2)}$$

In one aspect of a surface acoustic wave device according to the present invention, the thickness of the second silicon oxide film ranges from 0.16λ to 0.40λ. In this case, the electromechanical coupling coefficient $K_{SAW}^2$ of a Rayleigh wave, which is a main response to be utilized, is 6% or more. Thus, the bandwidth of a surface acoustic wave device can be increased.

In another aspect of the present invention, the Euler angle θ of the $LiNbO_3$ substrate ranges from 34.5° to 37.5°. In this case, the abnormal frequency shift at turn-on can be reduced effectively.

In still another aspect of the present invention, the thickness of the second silicon oxide film disposed on the IDT electrode ranges from 0.16λ to 0.30λ. In this case, the electromechanical coupling coefficient $K_{SAW}^2$ of a higher-mode Rayleigh wave is 0.5% or less. Thus, the generation of a spurious component due to the higher-mode Rayleigh wave can be reduced.

In still another aspect of the present invention, the duty ratio of the IDT electrode is less than 0.5. In this case, the abnormal frequency shift at turn-on can be reduced more effectively.

In still another aspect of a surface acoustic wave device according to the present invention, the film thickness of the IDT electrode is 0.04λ or less. In this case, the abnormal frequency shift at turn-on can be reduced.

In still another aspect of a surface acoustic wave device according to the present invention, the ratio of the cross width to the number of pairs of electrode fingers of the IDT electrode ranges from 0.075λ to 0.25λ. In this case, the abnormal frequency shift at turn-on can be reduced effectively.

Advantages

A surface acoustic wave device according to the present invention includes a $LiNbO_3$ substrate having Euler angles (0° ± 5°, θ, 0° ± 10°); electrodes and a first silicon oxide film each disposed on the $LiNbO_3$ substrate, the electrodes including at least one IDT electrode and having the same thickness as the first silicon oxide film; and a second silicon oxide film disposed on the electrodes and the first silicon oxide film. As such, the first silicon oxide film and the second silicon oxide film improve the frequency-temperature characteristics.

In addition, the IDT electrode mainly composed of Cu has a density at least 1.5 times as high as that of the first silicon oxide film. Thus, as in the surface acoustic wave device described in Patent Document 1, the generation of ripples in the resonance characteristics can be reduced.

Furthermore, the Euler angle θ and the normalized thickness H of the second silicon oxide film satisfy the formula (1) or (2). As is clear from the examples described below, this can effectively reduce the generation of a spurious component due to an SH wave at a frequency higher than an antiresonance frequency of a fundamental Rayleigh wave response. This is because the electromechanical coupling coefficient $K_{SAW}^2$ of the SH wave is reduced to as low as 0.1% or less.

Thus, the present invention can provide a surface acoustic wave device that is rarely affected by a spurious component due to an SH wave and that has excellent resonance characteristics and filter characteristics.

Brief Description of Drawings

Fig. 1(a) is a schematic plan view of a surface acoustic wave device according to one embodiment of the present invention; Fig. 1(b) is a partially cutaway enlarged front cross-sectional view of a principal part thereof.

Fig. 2 is a graph illustrating the electromechanical coupling coefficient $K_{SAW}^2$ of a Rayleigh wave as a function of θ of Euler angles (0°, θ, 0°) and the thickness of a second silicon oxide film in the first embodiment.

Fig. 3 is a graph illustrating the electromechanical coupling coefficient $K_{SAW}^2$ of a spurious component due to an SH wave as a function of θ of the Euler angles (0°, θ, 0°) and the thickness of the second silicon oxide film in the first embodiment.

Fig. 4 is a graph illustrating a region having an electromechanical coupling coefficient $K_{SAW}^2$ of the SH wave of 0.1% or less as a function of the thickness of the second silicon oxide film and θ of the Euler angles (0°, θ, 0°).

Fig. 5(a) is a graph illustrating the electromechanical coupling coefficient $K_{SAW}^2$ as a function of the Euler angle θ of a $LiNbO_3$ substrate for various thicknesses of a Cu IDT electrode, in which the duty ratio of the IDT electrode is 0.5 and the thickness of a second silicon oxide film is 0.3λ; Fig. 5(b) is a graph illustrating the electromechanical coupling coefficient $K_{SAW}^2$ as a function of the Euler angle θ of a $LiNbO_3$ substrate for various thicknesses of a Cu IDT electrode, in which the duty ratio of the IDT electrode is 0.5 and the thickness of a second silicon oxide film is 0.4λ.

Fig. 6 is a graph illustrating the impedance and the phase as a function of frequency in a surface acoustic wave device according to one embodiment of the present invention, when the thickness of a second silicon oxide film is 0.24λ, 0.29λ, or 0.34λ.

Fig. 7 is a graph illustrating the attenuation as a function of frequency in a surface wave duplexer for use in PCS according to another embodiment of the present invention and a comparative surface wave duplexer.

Fig. 8 is a graph illustrating the rate of divergence representing the frequency shift at turn-on as a function of θ of Euler angles (0°, θ, 0°).

Fig. 9 is a graph illustrating the rate of divergence representing the abnormal frequency shift at turn-on as a function of the duty ratio of an IDT electrode.

Fig. 10 is a graph illustrating the rate of divergence as a function of the thickness of a Cu IDT electrode.

Fig. 11 is a graph illustrating the rate of divergence as a function of the thickness of a SiN film, which serves as a frequency adjustment film.

Fig. 12 is a graph illustrating the rate of divergence as a function of the ratio of the cross width to the number of pairs of electrode fingers of an IDT electrode.

Fig. 13 is a graph illustrating the attenuation as a function of frequency in a high-frequency region in a surface wave duplexer for use in PCS.

Fig. 14 is a graph illustrating the electromechanical coupling coefficient $K_{SAW}^2$ of a higher-mode Rayleigh wave as a function of the thickness of a second silicon oxide film in the surface wave duplexer described in Fig. 13.

Reference Numerals

| | |
|---|---|
| 1 | surface acoustic wave device |
| 2 | $LiNbO_3$ substrate |
| 3 | IDT electrode |
| 4 and 5 | reflector |
| 6 | first silicon oxide film |
| 7 | second silicon oxide film |

Best Modes for Carrying Out the Invention

The present invention will be further described below with specific embodiments of the present invention with reference to the attached drawings.

Fig. 1(a) is a schematic plan view of a surface acoustic wave device according to one embodiment of the present invention; Fig. 1(b) is a partially cutaway enlarged front cross-sectional view of a principal part thereof.

A surface acoustic wave device 1 includes a rotated Y-cut X-propagating $LiNbO_3$ substrate 2. The $LiNbO_3$ substrate 2 has the crystal orientation of Euler angles (0°, θ, 0°).

As illustrated in Fig. 1(b), an IDT electrode 3 is disposed on the $LiNbO_3$ substrate 2. As illustrated in Fig. 1(a), reflectors 4 and 5 are disposed on both sides of the IDT electrode 3 in the propagation direction of a surface wave.

These electrodes are surrounded by a first silicon oxide film 6. The first silicon oxide film 6 has the same thickness as the IDT electrode 3 and the reflectors 4 and 5. These electrodes and the first silicon oxide film 6 are covered with a second silicon oxide film 7.

In the surface acoustic wave device 1, the $LiNbO_3$ substrate has a negative temperature coefficient of frequency. On the other hand, the first silicon oxide film 6 and the second silicon oxide film 7 have a positive temperature coefficient of frequency. This combination can improve the frequency characteristics.

Furthermore, the density of the electrodes including the IDT electrode 3 is at least 1.5 times the density of the first silicon oxide film 6. In the present embodiment, the IDT electrode 3 is composed of Cu. The density of the IDT electrode 3 is 8.93 g/cm$^3$, and the density of the first silicon oxide film is 2.21 g/cm$^3$.

Thus, as described in Patent Document 1, the IDT electrode 3 can have an increased reflection coefficient. This is believed to reduce the generation of ripples in the resonance characteristics.

In the surface acoustic wave device 1 according to the present embodiment, the Euler angle θ of the $LiNbO_3$ substrate 2 and the normalized thickness H of the second silicon oxide film 7 satisfy the formula (1) or (2) described below. This results in an effective reduction in the generation of a spurious component at a frequency higher than the antiresonance frequency of Rayleigh wave response. The present invention will be further described in the following examples.

[Formula 3]

$$-50 \times H^2 - 3.5 \times H + 38.275 \leq \{\theta\} \leq 10H + 35 \quad (\text{wherein } H < 0.25)$$

Formula (1)

[Formula 4]

$$-50 \times H^2 - 3.5 \times H + 38.275 \leq \{\theta\} \leq 37.5 \quad (\text{wherein } H \geq 0.25)$$

Formula (2)

EXAMPLE 1

A plurality of $LiNbO_3$ substrates having different θs of Euler angles (0°, θ, 0°) was prepared. A Cu IDT electrode 3 having a thickness of 0.04λ and a duty ratio of 0.50 was formed on the $LiNbO_3$ substrate 2. The number of electrode finger pairs of the IDT electrode 3 was 120. The cross width of the electrode finger pairs was 32.3 μm. Furthermore, reflectors 4 and 5 formed of the same material as the IDT electrode 3 and having the same thickness as the IDT electrode 3 were formed on both sides of the IDT electrode 3 in the propagation direction of a surface wave. Each of the reflectors 4 and 5 has 20 electrode fingers.

The surface acoustic wave device 1 was produced as follows. The first silicon oxide film was formed on the $LiNbO_3$ substrate by sputtering. After a resist pattern was formed on the first silicon oxide film, the first silicon oxide film was etched by reactive ion etching to form grooves for electrodes on the $LiNbO_3$ substrate. The grooves were filled with Cu to form the IDT electrode 3 and reflectors 4 and 5.

The second silicon oxide film was then formed by sputtering. The surface acoustic wave device 1 was thus produced with the second silicon oxide film having a thickness of 0.15λ, 0.20λ, 0.25λ, 0.30λ, 0.357λ, or 0.40λ.

Fig. 2 shows the electromechanical coupling coefficient $K_{SAW}^2$ of a Rayleigh wave as a function of Euler angle θ and the thickness of the second silicon oxide film in the surface acoustic wave device 1.

Fig. 2 shows that the electromechanical coupling coefficient $K_{SAW}^2$ increases with decreasing thickness of the second silicon oxide film. Fig. 2 also shows that the electromechanical coupling coefficient $K_{SAW}^2$ is large at an Euler angle θ in the range of 30° to 45°, particularly in the range of 35° to 40°.

Thus, the electromechanical coupling coefficient $K_{SAW}^2$ of a Rayleigh wave varies with the Euler angle θ and the thickness of the second silicon oxide film.

Fig. 3 shows the electromechanical coupling coefficient $K_{SAW}^2$ of a spurious component due to an SH wave as a function the Euler angle θ and the thickness of the second silicon oxide film 7 in the surface acoustic wave device 1.

Fig. 3 shows that the electromechanical coupling coefficient $K_{SAW}^2$ of an SH wave increases with decreasing thickness of the second silicon oxide film 7. Fig. 3 also shows that the electromechanical coupling coefficient $K_{SAW}^2$ of an SH wave is small at an Euler angle θ in the range of 30° to 40° and smallest at about 35°.

On the basis of the results shown in Figs. 2 and 3, Fig. 4 shows a region in which the Euler angle θ and the normalized thickness H of the second silicon oxide film provide the electromechanical coupling coefficient $K_{SAW}^2$ of a spurious component due to an SH wave of 0.1% or less (hatched region). In the hatched region in Fig. 4 where the electromechanical coupling coefficient $K_{SAW}^2$ of an SH wave is 0.1% or less, the spurious component due to the SH wave is substantially negligible when the surface acoustic wave device 1 is used.

The hatched region in Fig. 4 satisfies the formula (1) or (2).

Thus, when the Euler angle θ of the $LiNbO_3$ substrate 2 and the thickness of the second silicon oxide film 7 are selected to satisfy the formula (1) or (2), the electromechanical coupling coefficient $K_{SAW}^2$ of a spurious component due to an SH wave can be 0.1% or less.

EXAMPLE 2

Another surface acoustic wave device that includes a second silicon oxide film having a thickness of 0.3λ or 0.4λ and an IDT electrode having a thickness of 0.02λ, 0.04λ, or 0.06λ was produced in the same way as the surface acoustic wave device 1 according to Example 1. Figs. 5(a) and 5(b) show the electromechanical coupling coefficient of an SH wave as a function of Euler angle θ and the thickness of the IDT electrode in the surface acoustic wave device 1 according to Example 2. Figs. 5(a) and 5(b) show the results for the thickness of the second silicon oxide film 7 of 0.3λ and 0.4λ, respectively.

Figs. 5(a) and 5(b) show that, in both cases, the relationship between the Euler angle θ and the thickness H of the second silicon oxide film 7 that provides the electromechanical coupling coefficient $K_{SAW}^2$ of 0.1 % or less does not change significantly, even when the thickness of the IDT electrode 3 varies within the range of 0.02λ to 0.06λ.

In the practical use of the surface acoustic wave device 1, the electromechanical coupling coefficient $K_{SAW}^2$ of a Rayleigh wave should be at least 5%. Accordingly, as shown in Fig. 2, the thickness of the second silicon oxide film is desirably 0.4λ or less. Furthermore, as shown in Fig. 4, the thickness of the second silicon oxide film is preferably at least 0.16λ.

EXAMPLE 3

To verify the results shown in Fig. 4, the frequency characteristics of a surface acoustic wave device were examined. A single-port surface acoustic wave resonator having a resonance frequency of 1.9 GHz was produced using a $LiNbO_3$ substrate having Euler angles (0°, 34°, 0°). The λ was 2.07 μm.

More specifically, a first silicon oxide film having a thickness of 0.039λ was formed on the $LiNbO_3$ substrate 2. After a resist pattern was formed on the first silicon oxide film, the first silicon oxide film was selectively etched by reactive ion etching to form grooves for electrodes. The grooves were filled with Cu to form an IDT electrode 3 and reflectors 4 and 5. These electrodes had a thickness of 0.039λ = 80 nm. A second silicon oxide film 7 was then formed on the IDT electrode to produce a surface acoustic wave device. The thickness of the second silicon oxide film 7 was 500 nm (0.24λ), 600 nm (0.29λ), or 700 nm (0.34λ).

Fig. 6 shows the impedance and the phase as a function of frequency in the surface acoustic wave device 1 thus produced.

Fig. 6 shows the presence of a very large spurious component, as indicated by an arrow A, probably due to an SH wave at a frequency higher than the antiresonance frequency when the thickness of the second silicon oxide film 7 was 500 nm or 0.24λ. By contrast, such a large spurious component did not occur at a frequency higher than the antiresonance frequency when the thickness of the second silicon oxide film was 600 nm (0.29λ) or 700 nm (0.34λ).

At θ = 34°, the thickness of the second silicon oxide film of 0.29λ or 0.34λ satisfies the formula (2). Thus, the spurious component due to an SH wave can be reduced. By contrast, the thickness of the second silicon oxide film of 500 nm or 0.24λ satisfies neither formula (1) nor formula (2), thus resulting in the generation of the large spurious component due to an SH wave.

EXAMPLE 4

A duplexer for use in PCS was produced in the same way as the single-port surface acoustic wave resonator described above. The waveform of a band-pass filter in the duplexer was measured. The electrode material was composed of Cu. The thickness of an electrode and a first silicon oxide film 6 was 0.05λ (98 nm). The thickness of the second silicon oxide film 7 was 0.27λ (531 nm). A SiN frequency adjustment film was formed on the second silicon oxide film 7 to adjust the frequency. More specifically, the thickness of the SiN film was adjusted while the SiN film was formed. Alternatively, after the SiN film was formed, the SiN film was etched by reactive ion etching or ion milling to reduce the thickness, thus achieving a desired frequency. The frequency adjustment film may be formed of another material, such as SiC or Si.

Fig. 7 shows the attenuation as a function of frequency in a band-pass filter of the surface wave duplexer for use in PCS thus produced. Fig. 7 shows two examples. In one example (broken line), the Euler angle θ was 32°, and neither the formula (1) nor the formula (2) were satisfied. In the other example (solid line), the Euler angle θ was 36°, and the formula (1) was satisfied. Two curves shown in a lower part of Fig. 7 are the attenuations expressed with an enlarged scale shown on the right side of the vertical axis.

Fig. 7 shows that a large spurious component due to an SH wave occurs in the passband at an Euler angle θ of 32°, as indicated by an arrow B. By contrast, no spurious component occurs when the formula (1) is satisfied at an Euler angle θ of 36°.

EXAMPLE 5

The same surface acoustic wave device 1 as described above was produced, and the frequency variation at turn-on was measured. More specifically, a surface acoustic wave device 1 was produced as in Example 1, except that the thickness of the Cu IDT electrode and the first silicon oxide film was 0,05λ, the thickness of the second silicon oxide film 7 was 0.30λ, and a SiN film having a thickness of 15 nm was formed as a frequency adjustment film on the second silicon oxide film. The duty ratio of the IDT electrode 3 was 0.55. The $LiNbO_3$ substrate 2 had an Euler angle θ of 30°, 34°, 36°, or 38°. Fig. 8 shows the rate of divergence representing the frequency shift at turn-on as a function of Euler angle θ in the surface acoustic wave device 1. The rate of divergence was calculated by the following equation.

Rate of divergence = (frequency variation when an electric power of 0.9 W is applied)/(frequency variation based on TCF when the temperature increases to 60°C)

Thus, in the surface acoustic wave device, when power is turned on, the temperature increases from room temperature to about 60°C. An increase in temperature at turn-on somewhat varies the frequency. The rate of divergence was defined by the ratio of a frequency variation at the application of an electric power of 0.9 W to a frequency variation due to an increase in temperature. Thus, at a rate of divergence of 1, the frequency variation is caused only by an increase in temperature. An increase in rate of divergence indicates the presence of abnormal frequency shift, in addition to the frequency variation due to an increase in temperature.

For example, in a surface acoustic wave device having a TCF of -5 ppm/°C, the frequency variation caused by a temperature increase to 60°C is estimated to be -300 ppm. When the frequency variation due to the application of an electric power of 0.9 W is -900 ppm, the rate of divergence is (-900)/(-300) = 3.

Fig. 8 shows that the rate of divergence is almost one at an Euler angle θ of about 36°, indicating the substantial absence of abnormal frequency shift. The rate of divergence increases as the Euler angle θ departs from 36°.

While the rate of divergence is ideally one, a rate of divergence of 2.5 or less can be achieved at an Euler angle θ in the range of 34.5° to 37.5°, as shown in Fig. 8.

Hence, in the present invention, the Euler angle θ preferably ranges from 34.5° to 37.5°.

At a rate of divergence of more than 2.5, the frequency variation is too large to stabilize the characteristics at turn-on.

EXAMPLE 6

A surface acoustic wave device 1 was produced as in Example 5, except that the $LiNbO_3$ substrate had the Euler angle θ of 34°, the thickness of the second silicon oxide film 7 was 0.30λ, and the duty ratio of the IDT electrode 3 ranged from 0.2 to 0.65. Fig. 9 shows the rate of divergence in the surface acoustic wave device 1.

Fig. 9 shows that the rate of divergence advantageously decreases with decreasing duty ratio of the IDT electrode. A rate of divergence of 2.5 or less can be achieved at a duty ratio of the IDT electrode of 0.5 or less.

However, an excessively low duty ratio of the IDT electrode results in an excessively high electrode resistance, thus making the use of the surface acoustic wave device difficult. The duty ratio of the IDT electrode is therefore preferably at least 0.25. Thus, the duty ratio of the IDT electrode preferably ranges from 0.25 to 0.5.

EXAMPLE 7

A surface acoustic wave device 1 was produced as in Examples 5 and 6, except that the $LiNbO_3$ substrate 2 had an Euler angle θ of 34°, the duty ratio of the Cu IDT electrode 3 was 0.55, the thickness of the second silicon oxide film 7 was 0.30λ, an SiN frequency adjustment film having a thickness of 15 nm was formed at the top, and the thickness of the Cu IDT electrode 3 ranged from 0.03λ to 0.05λ. Fig. 10 shows the rate of divergence as a function of the thickness of the Cu IDT electrode 3 in the surface acoustic wave device 1.

Fig. 10 shows that the rate of divergence decreases with decreasing thickness of the IDT electrode 3. A rate of divergence of 2.5 or less can be achieved at a thickness of the IDT electrode 3 of 0.04λ or less. The thickness of the IDT electrode 3 is therefore preferably 0.04λ or less.

EXAMPLE 8

A surface acoustic wave device 1 was produced as in Example 7, except that the SiN frequency adjustment film had a thickness of 15 or 25 nm. For purposes of comparison, a surface acoustic wave device without a SiN film was also produced. Other parameters were the same as in Example 7; that is, the Euler angle θ was 34°, the IDT electrode was composed of Cu and had a thickness of 0.05λ, and the second silicon oxide film had a thickness of 0.30λ.
Fig. 11 shows the results. Fig. 11 shows that the rate of divergence decreases with increasing the thickness of the SiN film thickness. Thus, the SiN film preferably has a large thickness.

EXAMPLE 9

Surface acoustic wave devices having different ratio of the cross width to the number of pairs of electrode fingers of the IDT electrode 3 were produced to investigate the relationship between the cross width and the number of pairs of electrode fingers. The $LiNbO_3$ substrate 2 had an Euler angle θ of 34°, the thickness of the Cu IDT electrode 3 was 0.05λ, the thickness of the second silicon oxide film 7 was 0.30λ, the thickness of the SiN frequency adjustment film was 15 nm, and the duty ratio of the IDT electrode 3 was 0.55. The ratio of the cross width to the number of pairs of electrode fingers was 0.058λ, 0.077λ, 0.11 λ, or 0.23λ.
The cross width refers to the length of crossing portions, in the propagation direction of a surface wave, of adjacent electrode fingers having different electric potentials in the IDT electrode 3.
Fig. 12 shows that the rate of divergence is four or less at a ratio of the cross width to the number of pairs of electrode fingers in the range of 0.075λ to 0.25λ. Thus, this range is preferred. The rate of divergence is 2.5 or less at a ratio of the cross width to the number of pairs of electrode fingers in the range of 0.12λ to 0.2λ. Thus, this range is more preferred.

EXAMPLE 10

Fig. 13 shows the frequency characteristics of the surface wave duplexer for use in PCS described above in a high-frequency region of at least 1500 MHz. The frequency characteristics show in Fig. 13 corresponds to those in a high-frequency region of the frequency characteristics shown in Fig. 7.
Fig. 13 shows the presence of a spurious component, as indicated by an arrow C, at about 2300 MHz, which is higher than the frequency of Rayleigh wave response of interest. This spurious component is caused by a higher-mode Rayleigh wave. While the spurious component is apart from a fundamental Rayleigh wave response to some extent, the spurious component is desirably small. The present inventors found that the spurious component due to the higher-mode Rayleigh wave can be reduced by altering the thickness of the second silicon oxide film 7.
Fig. 14 is a graph illustrating the electromechanical coupling coefficient $K_{SAW}^2$ of the higher-mode Rayleigh wave as a function of the thickness of the second silicon oxide film 7 in the surface wave duplexer described above. The $LiNbO_3$ substrate 2 had an Euler angle θ of 36°, the IDT electrode 3 was composed of Cu and had a thickness of 0.05λ, and the duty ratio was 0.50.
Fig. 14 shows that the spurious component due to a higher-mode Rayleigh wave was reduced with decreasing thickness of the second silicon oxide film 7. In particular, the electromechanical coupling coefficient of a higher-mode Rayleigh wave is said to be desirably 0.5% or less to achieve characteristically required attenuation. Accordingly, the thickness of the second silicon oxide film 7 is preferably 0.3λ or less.
While the electrodes, including the IDT electrode 3, were composed of Cu in the embodiments and the examples described above, the electrodes in the present invention may be formed of any material based on Cu. For example, the electrodes may be a film made of Cu, or may be a laminate film of a Cu film and a film formed of a metal other than Cu or an alloy film. The electrodes formed of a laminate film are mainly composed of a Cu film. The IDT electrode may be formed of an alloy mainly composed of Cu. The electrodes may be formed of a laminate mainly composed of an alloy film mainly composed of Cu.
The present invention can be applied to various resonators and surface wave filters of various circuitry, as well as the single-port surface acoustic wave resonator and the band-pass filter of the duplexer described above.

**Claims**

**1.** A surface acoustic wave device utilizing a Rayleigh wave, comprising:

a $LiNbO_3$ substrate having Euler angles (0° ± 5°, θ, 0° ± 10°);
electrodes that are disposed on the $LiNbO_3$ substrate, are mainly composed of Cu, and include at least one IDT electrode;
a first silicon oxide film having the same thickness as the electrodes and disposed in an area other than an area on which the electrodes are disposed; and
a second silicon oxide film disposed on the electrodes and the first silicon oxide film,
wherein the density of the electrodes is at least 1.5 times as high as the density of the first silicon oxide film, and the normalized thickness H of the second silicon oxide film and θ of the Euler angles (0° ± 5°, θ, 0° ± 10°) satisfy the formula (1) or (2).

$$-50 \times H^2 - 3.5 \times H + 38.275 \leq \{\theta\} \leq 10H + 35 \text{ (wherein } H < 0.25) \quad \text{Formula (1)}$$

$$-50 \times H^2 - 3.5 \times H + 38.275 \leq \{\theta\} \leq 37.5 \text{ (wherein } H \geq 0.25) \quad \text{Formula (2)}$$

**2.** The surface acoustic wave device according to Claim 1, wherein the thickness of the second silicon oxide film ranges from 0.16λ to 0.40λ.

**3.** The surface acoustic wave device according to Claim 1 or 2, wherein the Euler angle θ ranges from 34.5° to 37.5°.

**4.** The surface acoustic wave device according to any one of Claims 1 to 3, wherein the thickness of the second silicon oxide film ranges from 0.16λ to 0.30λ.

**5.** The surface acoustic wave device according to any one of Claims 1 to 4, wherein the duty ratio of the IDT electrode is less than 0.5.

**6.** The surface acoustic wave device according to any one of Claims 1 to 5, wherein the thickness of the electrodes is 0.04λ or less.

**7.** The surface acoustic wave device according to any one of Claims 1 to 6, wherein the ratio of the cross width to the number of pairs of electrode fingers of the IDT electrode ranges from 0.075λ to 0.25λ.

FIG.1

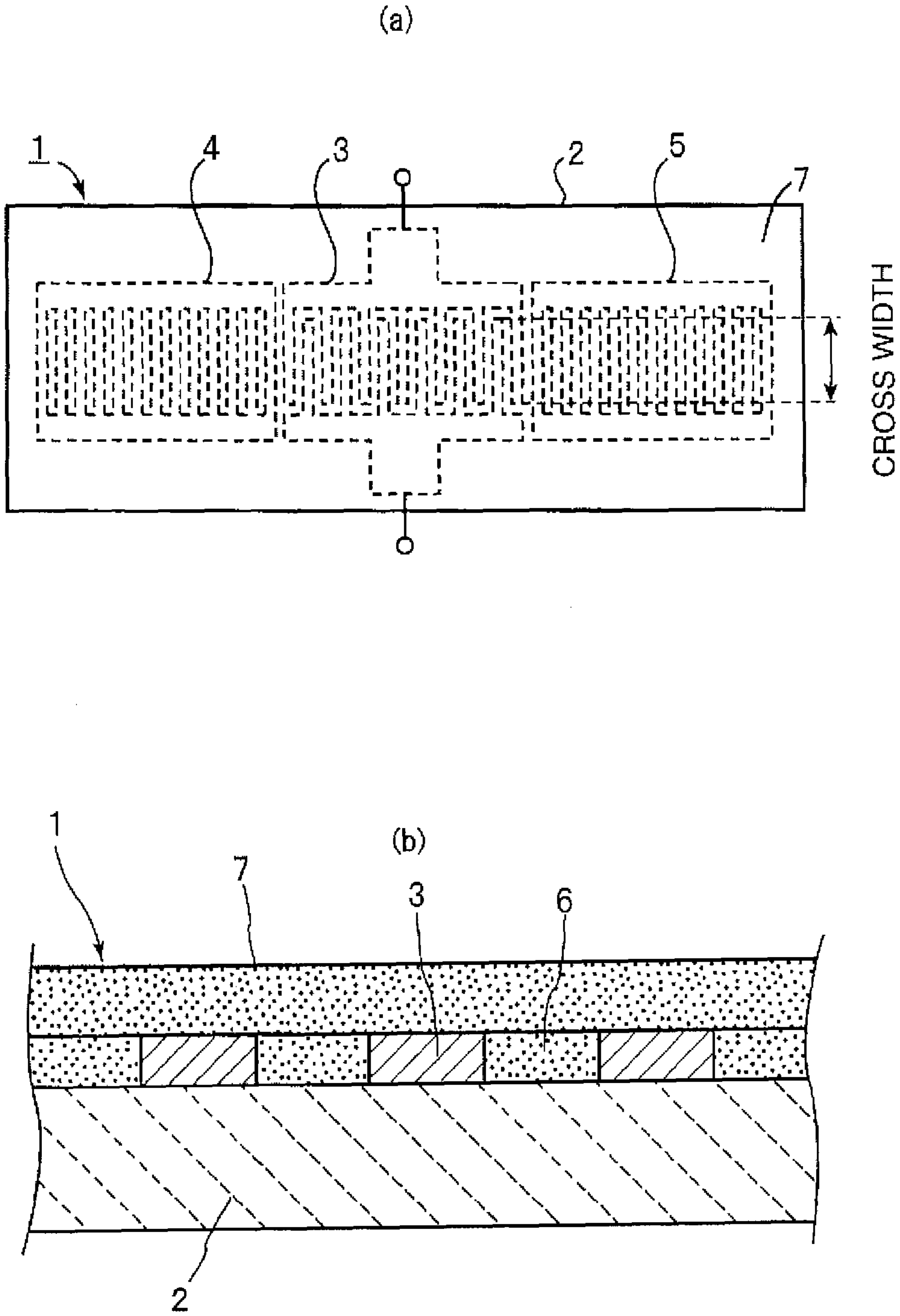

FIG.2

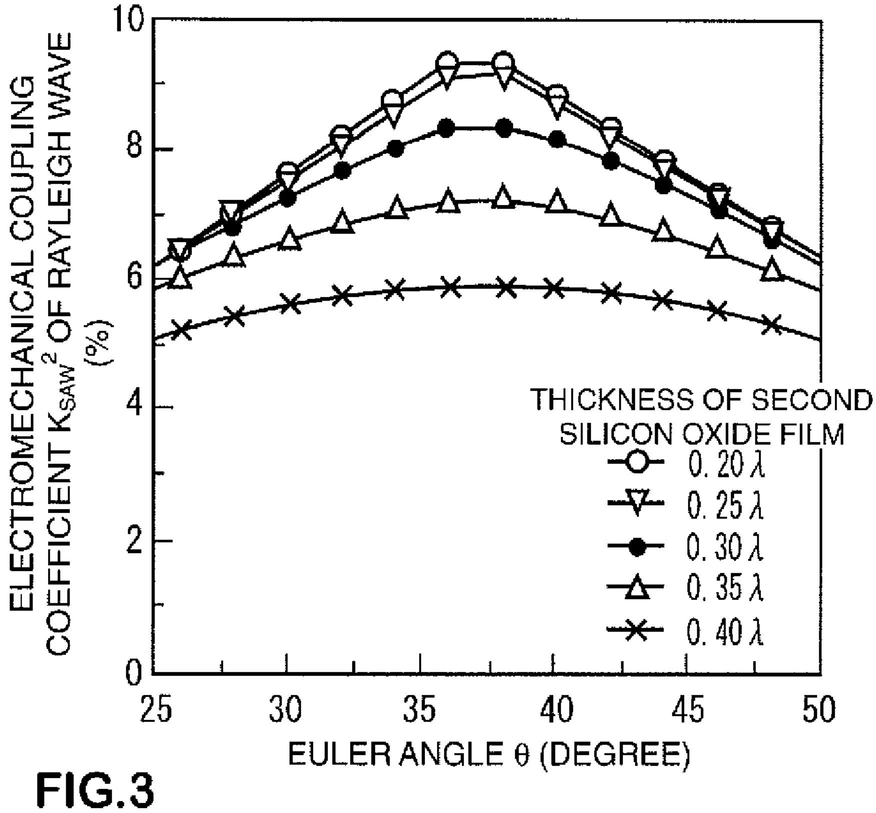
ELECTROMECHANICAL COUPLING COEFFICIENT $K_{SAW}^2$ OF RAYLEIGH WAVE (%)
0
2
4
6
8
10
25
30
35
40
45
50
EULER ANGLE θ (DEGREE)
THICKNESS OF SECOND SILICON OXIDE FILM
0.20λ
0.25λ
0.30λ
0.35λ
0.40λ

FIG.3

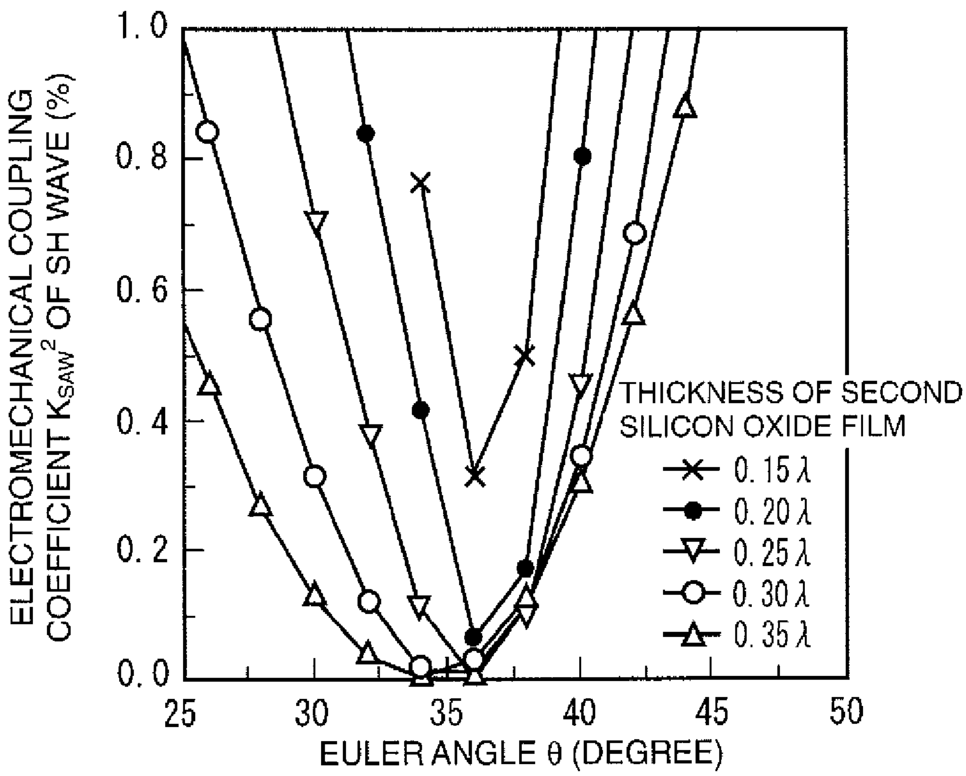
ELECTROMECHANICAL COUPLING COEFFICIENT $K_{SAW}^2$ OF SH WAVE (%)
0.0
0.2
0.4
0.6
0.8
1.0
25
30
35
40
45
50
EULER ANGLE θ (DEGREE)
THICKNESS OF SECOND SILICON OXIDE FILM
0.15λ
0.20λ
0.25λ
0.30λ
0.35λ

FIG.4

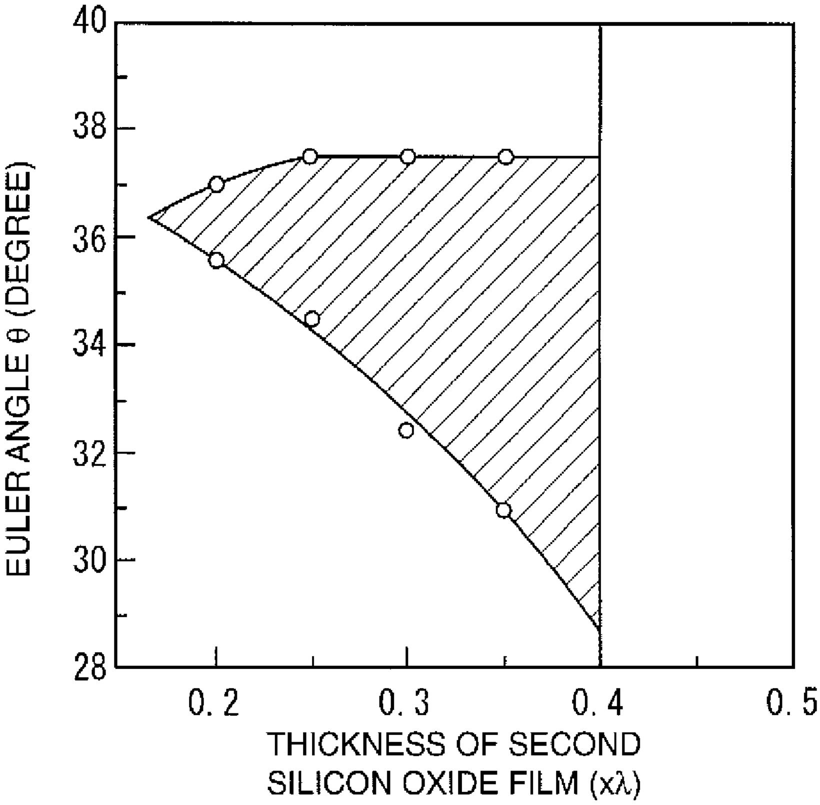
40
38
36
34
32
30
28
EULER ANGLE θ (DEGREE)
0. 2
0. 3
0. 4
0. 5
THICKNESS OF SECOND
SILICON OXIDE FILM (xλ)

FIG.5

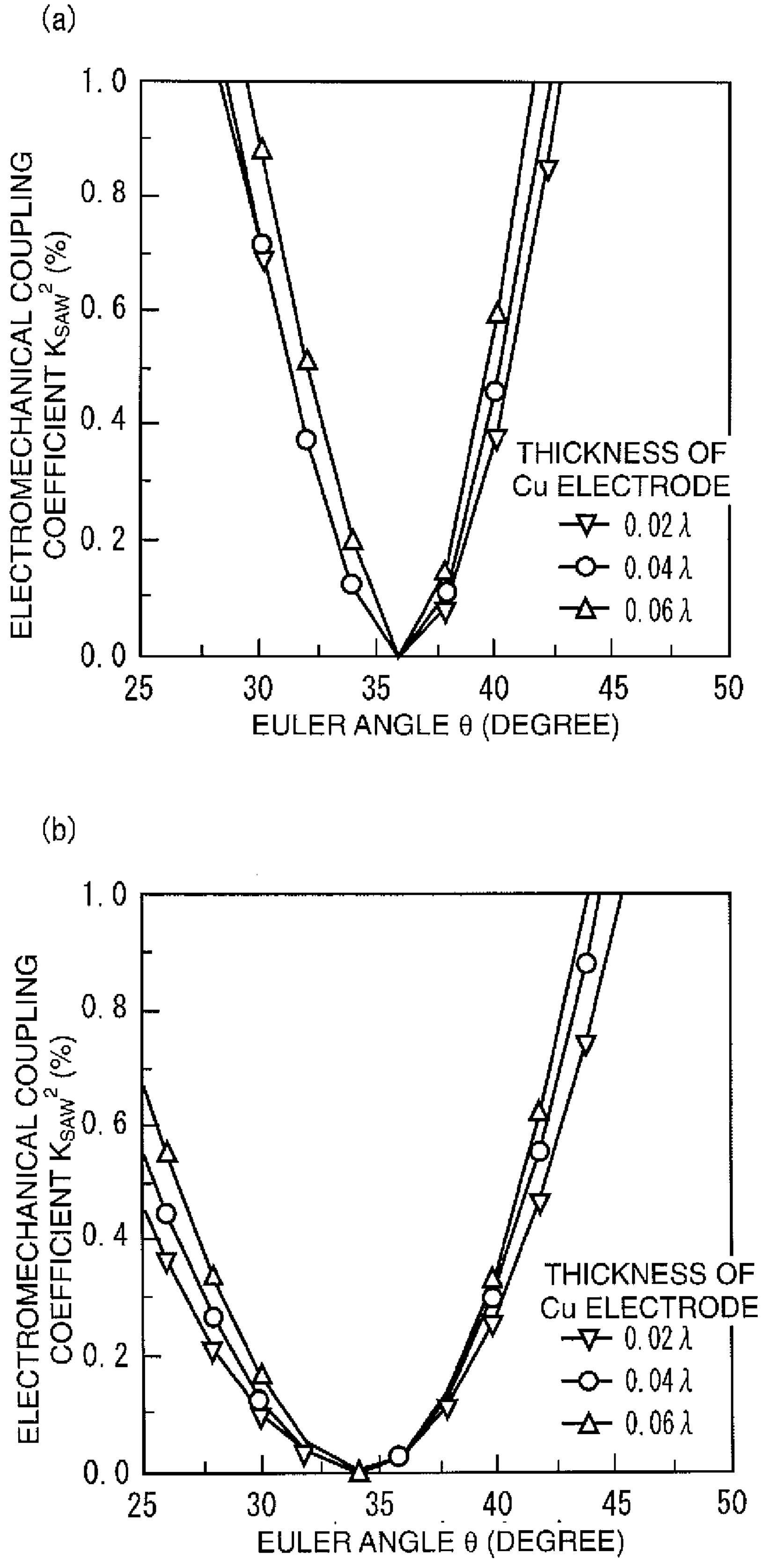
(a)
1.0
0.8
0.6
0.4
0.2
0.0
25
30
35
40
45
50
ELECTROMECHANICAL COUPLING COEFFICIENT K$_{SAW}^2$ (%)
EULER ANGLE θ (DEGREE)
THICKNESS OF Cu ELECTRODE
0.02λ
0.04λ
0.06λ
(b)
1.0
0.8
0.6
0.4
0.2
0.0
25
30
35
40
45
50
ELECTROMECHANICAL COUPLING COEFFICIENT K$_{SAW}^2$ (%)
EULER ANGLE θ (DEGREE)
THICKNESS OF Cu ELECTRODE
0.02λ
0.04λ
0.06λ

# FIG.6

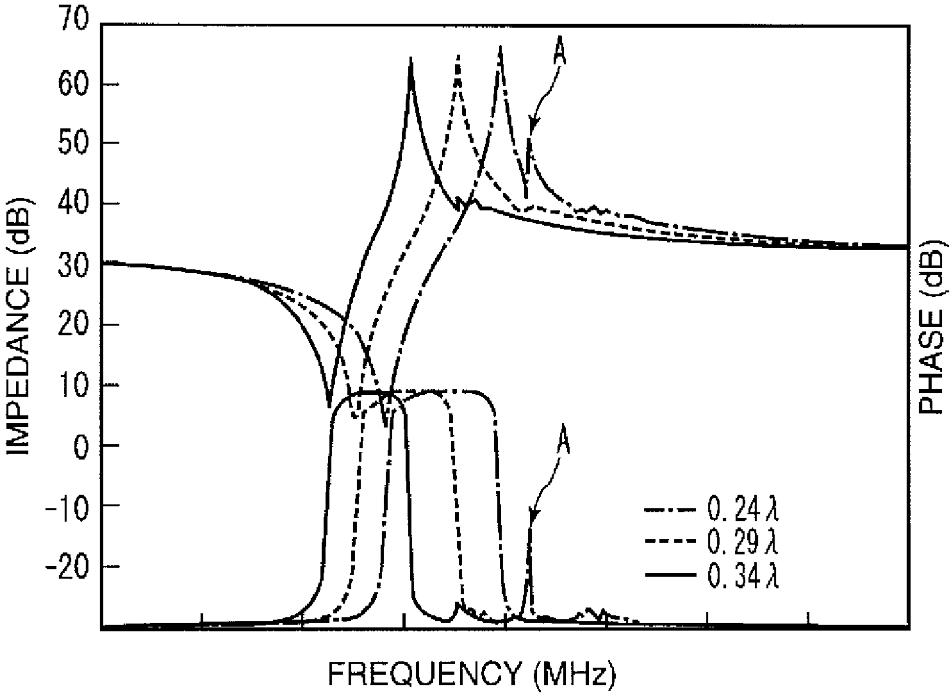
70
60
50
40
30
20
10
0
-10
-20
IMPEDANCE (dB)
PHASE (dB)
A
A
0.24λ
0.29λ
0.34λ
FREQUENCY (MHz)

# FIG.7

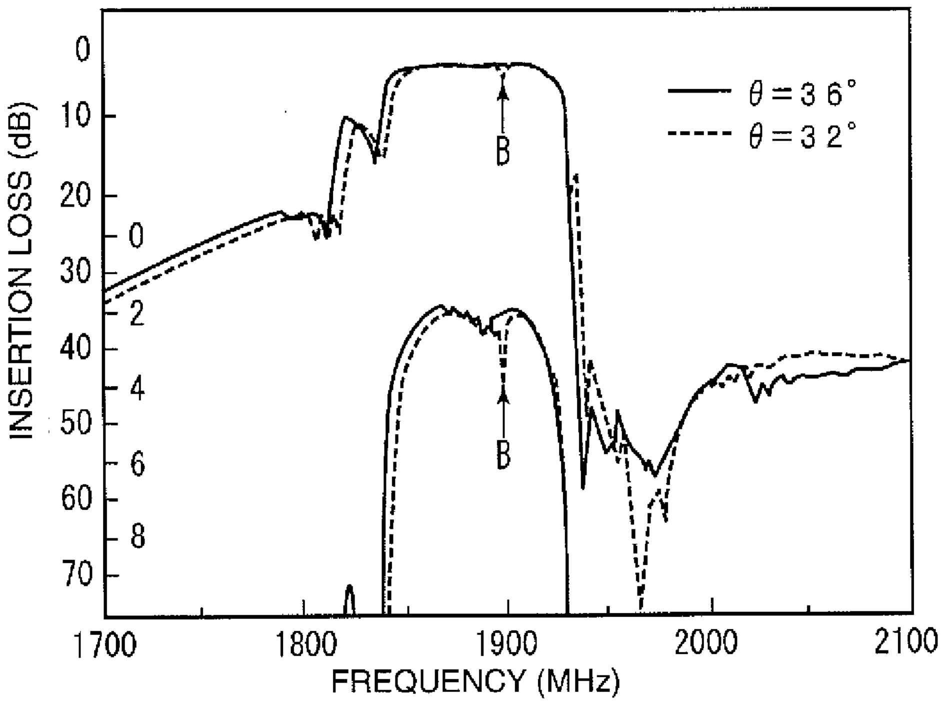
0
10
20
30
40
50
60
70
0
2
4
6
8
INSERTION LOSS (dB)
B
B
θ=36°
θ=32°
1700
1800
1900
2000
2100
FREQUENCY (MHz)

FIG.8

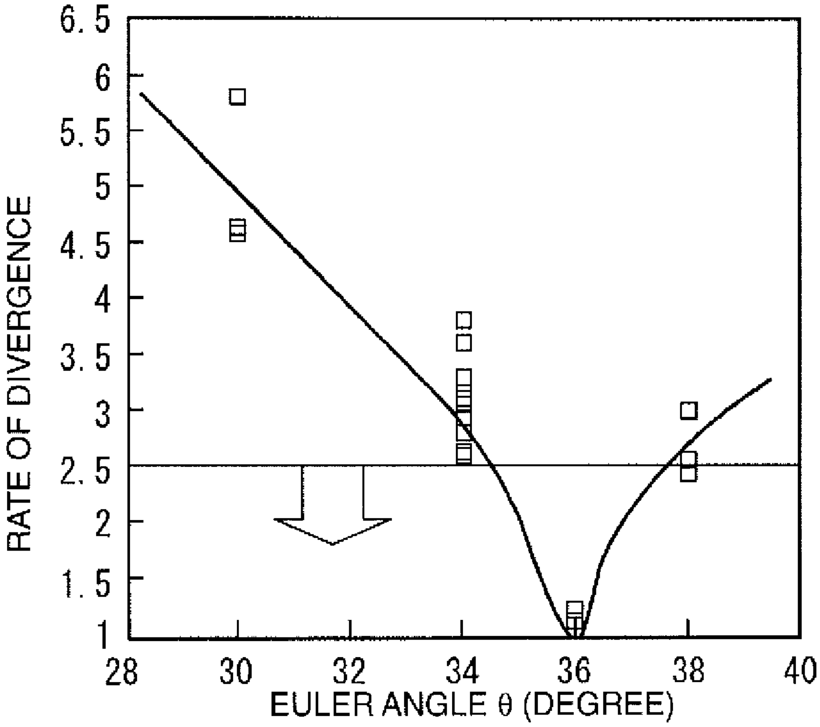
6.5
6
5.5
5
4.5
4
3.5
3
2.5
2
1.5
1
RATE OF DIVERGENCE
28
30
32
34
36
38
40
EULER ANGLE θ (DEGREE)

FIG.9

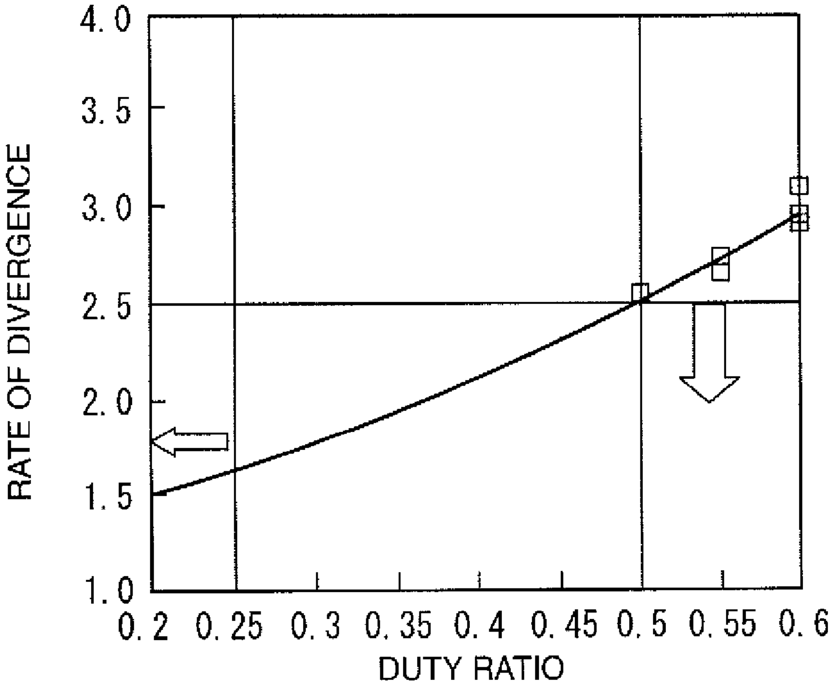
4.0
3.5
3.0
2.5
2.0
1.5
1.0
RATE OF DIVERGENCE
0.2
0.25
0.3
0.35
0.4
0.45
0.5
0.55
0.6
DUTY RATIO

FIG.10

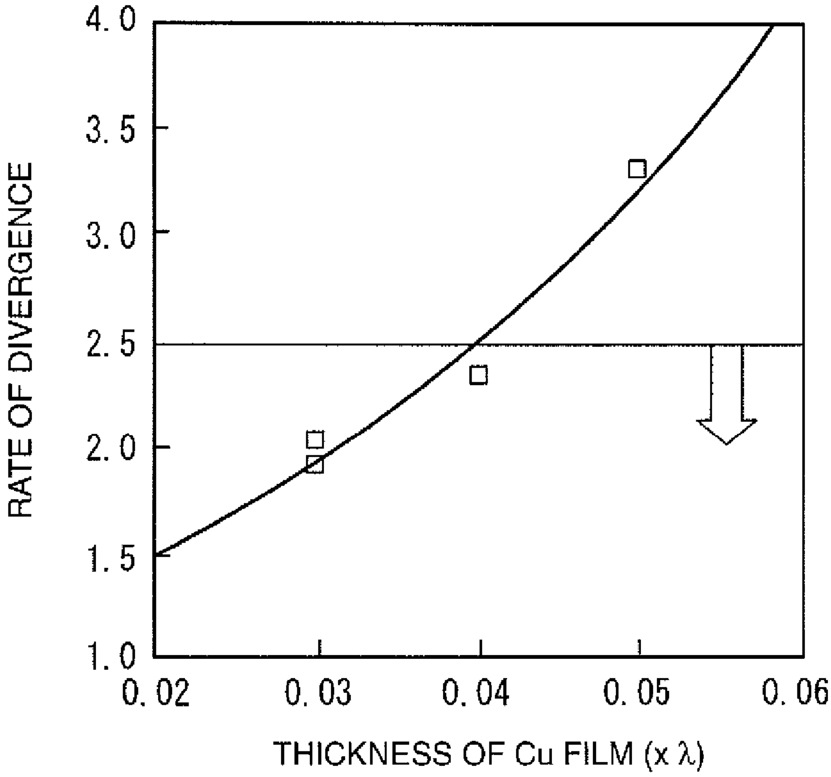
4.0
3.5
3.0
2.5
2.0
1.5
1.0
RATE OF DIVERGENCE
0.02
0.03
0.04
0.05
0.06
THICKNESS OF Cu FILM (x λ)

FIG.11

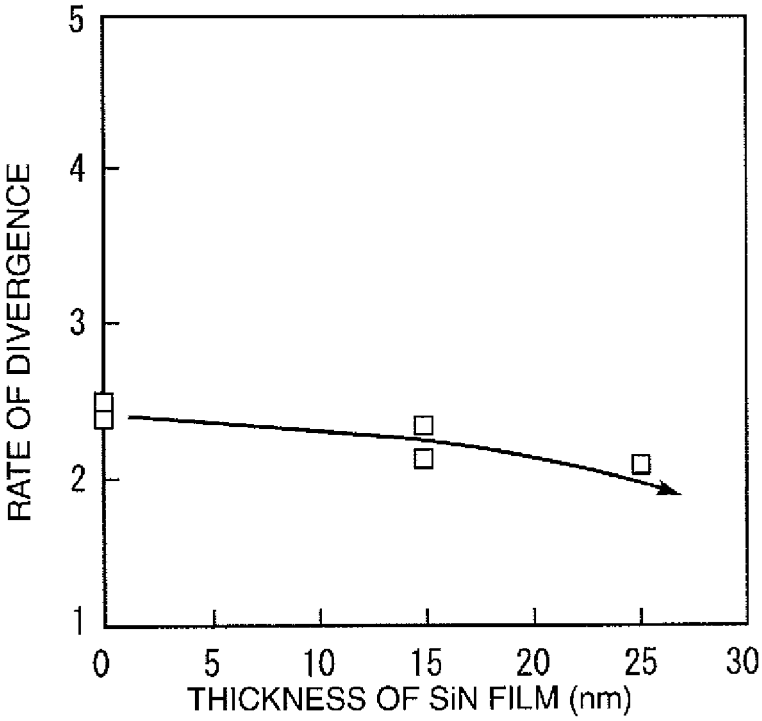
5
4
3
2
1
RATE OF DIVERGENCE
0
5
10
15
20
25
30
THICKNESS OF SiN FILM (nm)

FIG.12

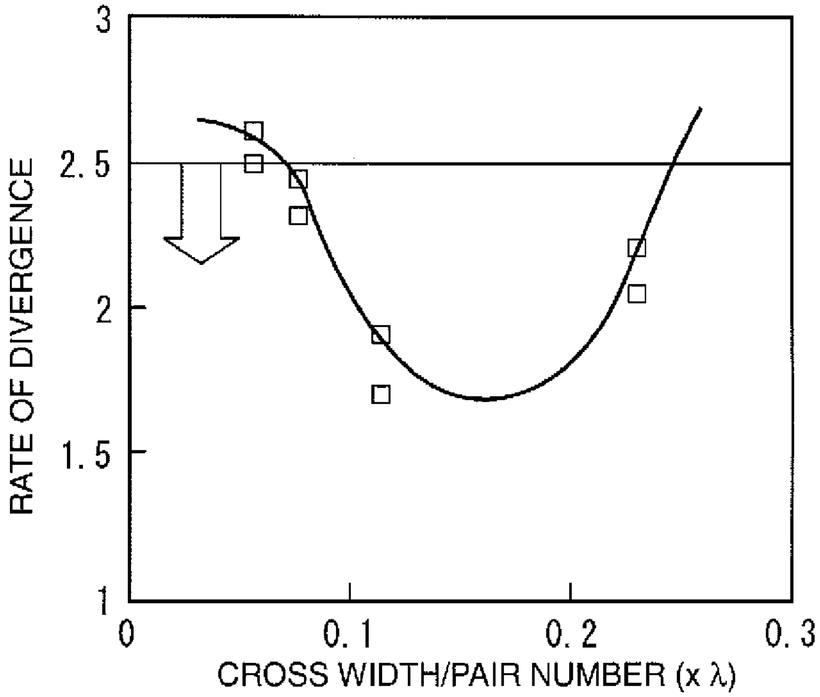
3
2. 5
2
1. 5
1
0
0. 1
0. 2
0. 3
RATE OF DIVERGENCE
CROSS WIDTH/PAIR NUMBER (x λ)

FIG.13

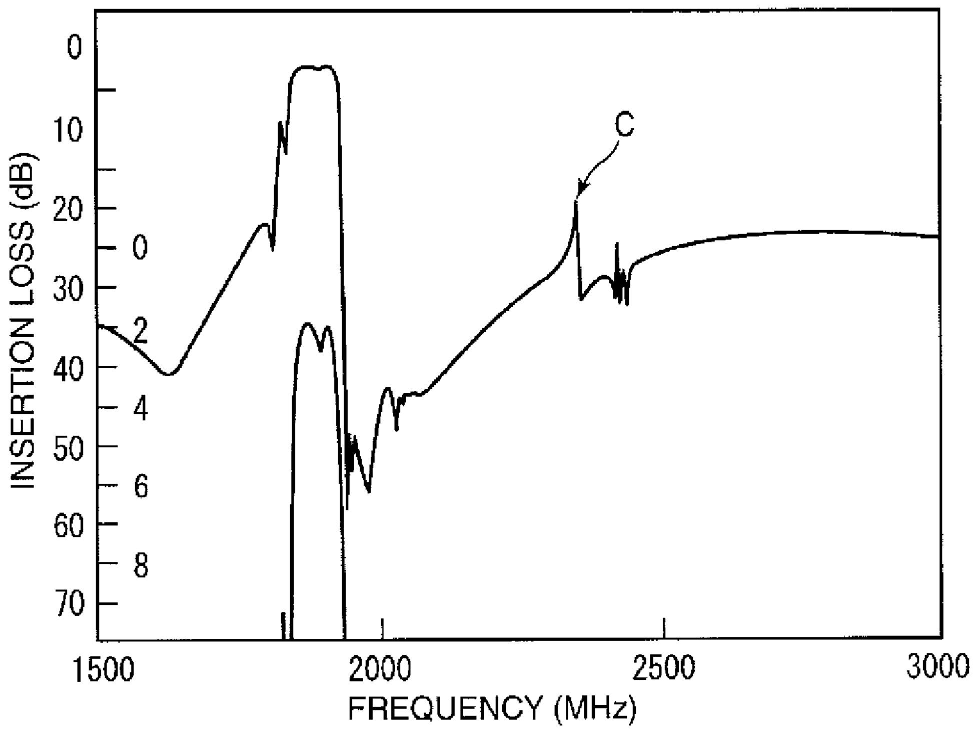
0
10
20
30
40
50
60
70
0
2
4
6
8
C
INSERTION LOSS (dB)
1500
2000
2500
3000
FREQUENCY (MHz)

FIG.14

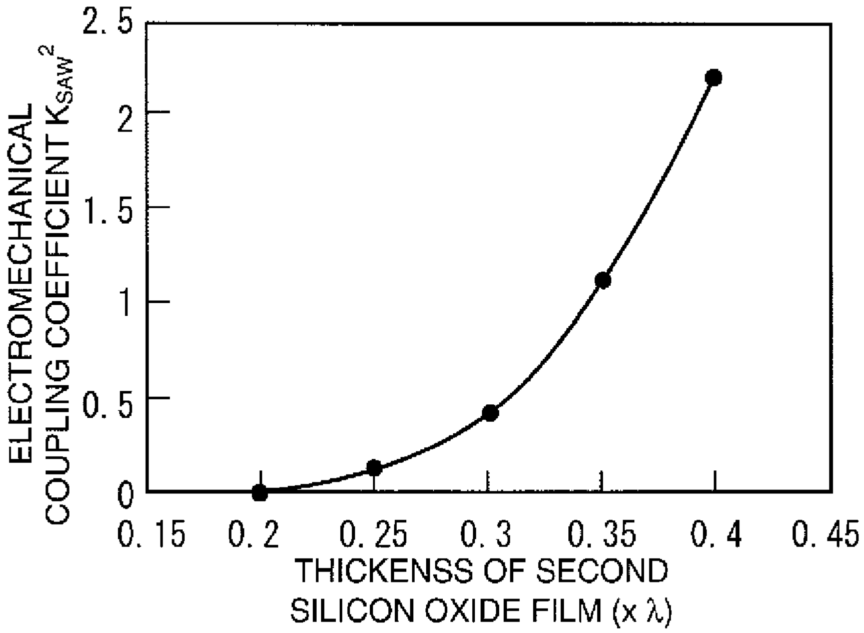
ELECTROMECHANICAL
COUPLING COEFFICIENT $K_{SAW}^2$
2. 5
2
1. 5
1
0. 5
0
0. 15
0. 2
0. 25
0. 3
0. 35
0. 4
0. 45
THICKENSS OF SECOND
SILICON OXIDE FILM (x λ)

**INTERNATIONAL SEARCH REPORT**

International application No.
PCT/JP2007/052017

A. CLASSIFICATION OF SUBJECT MATTER
*H03H9/25*(2006.01)i

According to International Patent Classification (IPC) or to both national classification and IPC

B. FIELDS SEARCHED

Minimum documentation searched (classification system followed by classification symbols)
H03H9/25

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | WO 2005/034347 A (Murata Mfg. Co., Ltd.), 14 April, 2005 (14.04.05), Claims; Par. No. [0080]; tables 1, 5; Fig. 5 (Family: none) | 1-4,6<br>5 |
| Y | WO 2005/011117 A (Murata Mfg. Co., Ltd.), 03 February, 2005 (03.02.05), Par. Nos. [0011], [0012] & US 2006/0131992 A | 5 |

☐ Further documents are listed in the continuation of Box C. ☐ See patent family annex.

* Special categories of cited documents:

"A" document defining the general state of the art which is not considered to be of particular relevance

"E" earlier application or patent but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| 18 May, 2007 (18.05.07) | 29 May, 2007 (29.05.07) |

| Name and mailing address of the ISA/ | Authorized officer |
|---|---|
| Japanese Patent Office | |
| Facsimile No. | Telephone No. |

Form PCT/ISA/210 (second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2005034347 A